# EUROPEAN PATENT APPLICATION

(11) **EP 0 798 725 A2**
(43) Date of publication of application: **01.10.1997**
(21) Application number: 97301391.5
(22) Date of filing: 03.03.1997
(51) Int. Cl.: G11C 5/00

(54) **Method and appartus for limiting voltage drop in computer systems**

(30) Priority: 29.03.1996 US 624159
(71) Applicant: International Business Machines Corporation, Armonk, N.Y. 10504 (US)
(72) Inventor: Lattimore, George McNeil, Austin, Texas 78750 (US); Schmidt, Steven Arthur, Leander, Texas 78641 (US); Topps, Avery Cox, Phoenix, Arizona 85044 (US)
(74) Representative: Zerbi, Guido Maria

(57) **Abstract**

The present invention, includes the ability to monitor various power consuming components in the computer system, and selectively maintain various ones of the components in a turned on state in order to eliminate a voltage spike. At least one control circuit is provided which receives inputs from various data processing elements and determines when none of these elements are accessing a power consuming component. When the control circuit does determine that a power consuming component is completely idle, then an access is made to that component such that a residual voltage level is maintained. Thus, when a subsequent data processing access occurs, the voltage drop (due to the surge in power to the consuming component) is minimized, or eliminated.

## Description

### BACKGROUND OF THE INVENTION

### Technical Field

The present invention generally relates to optimizing the performance of integrated circuits (ICs) in a computer system. More specifically, the present invention provides a mechanism for monitoring the state of various functional units in a computer system, and maintaining the units at a specific state having a predetermined voltage.

### Description of Related Art

In today's computer systems there are many design points which must be considered when developing new components, such as microprocessor chips, application specific integrated circuits (ASIC), adapter cards, system boards, and the like. Two of the most common design points are high processing frequency and power consumption. Further, fabrication technology is advancing to the stage where voltages on the order of 2.5 volts and even 1.8 volts are being used. In order to ensure the integrity of the ICs, the system must maintain at least 80% (approximately) of the rated voltage on the circuits in the system or face losing the information stored in the storage elements, such as buffers and registers. When various high power components are switched on and off a voltage transient is created which can drop the voltage at various points on the component. The voltage drop is dependent on characteristics, such as the resistance of the lines, distance of the point from the high power component, inductance, the presence of any capacitors and the like.

Typically, circuit designers prefer to include control circuitry in the systems which will turn off various components, when not in use, in order to save power. A problem exists when these components are then turned back on, because a voltage transient spike can occur which may cause the system voltage (Vdd) to drop to an unacceptably low level. When the voltage is too low, cycle time is lost during the time period required for the transient to return to its steady state level. During this time period no processing activity can occur and the system must remain idle. Furthermore, if the voltage transient is too severe data can be lost from storage elements, as noted above.

Conventional solutions include adding capacitive elements to the various circuits to counteract the inductance which is present in circuit lines, and the like. However, once a circuit is designed and implemented in silicon, there is no ability to go back and vary the capacitance without refabricating the entire chip. Typically, once a chip is fabricated, circuit designers are forced to live with whatever electrical characteristics are present in the chip at that time. It can be seen that it would be advantageous to have the ability to change the electrical power consumption by enabling various circuits, included in the chip, as needed. It can be seen that this capability would be desirable and provide a great deal of flexibility to circuit designers.

IBM Technical Disclosure Bulletin article "High Performance L1 Data Cache Power Management", volume 37, April 1994, pages 633-634 describes controlling power by blocking the clock signal to an array. Thus, when the clock to the array is inhibited the power requirement drops to zero.

IBM Technical Disclosure Bulletin, "Memory Circuits Power Gating Scheme", December 1972, pages 2114-2115 discusses a significant power saving advantage that can be realized by depowering the circuits as soon it is determined that the memory circuit is idle.

These references clearly show techniques for reducing power consumption in computer systems by depowering circuits which are not in use. However, by depowering idle circuits, the system becomes less reliable. The more circuits which are depowered, the greater chance of having an unacceptable voltage transient when the circuits are once again activated.

It can be seen that a need exists for a system which can monitor the use of various components in a computer and maintain a minimum acceptable level of voltage to the components. In this manner, overall system power could be reduced and reliability can be improved since the possibility of an unacceptable voltage transient is eliminated.

### Summary of the Invention

It is an object of the present invention to provide a technique which alleviates the above drawbacks.

According to the present invention we provide a circuit for maintaining a storage unit, connected to a plurality of data processing devices, in a predetermined state, comprising: means for determining when none of said plurality of data processing devices are accessing said storage unit; and means for initiating an access cycle to said storage unit when none of said plurality of data processing devices are accessing said storage unit.

Further according to the present invention we provide a method for maintaining a storage unit, connected to a plurality of data processing devices, in a predetermined state, comprising the steps of: determining when none of said plurality of data processing devices are accessing said storage unit; and initiating an access cycle to said storage unit when none of said plurality of data processing devices are accessing said storage unit.

In contrast to the prior art, the present invention, includes the ability to monitor various power consuming components in a computer system, and selectively maintain various ones of the components in a turned on state in order to eliminate a voltage spike.

Broadly, at least one control circuit is provided which receives inputs from various data processing elements and determines when none of these elements are accessing a power consuming component. When the control circuit does determine that a power consuming component is completely idle, then an access is made to that component such that a residual voltage level is maintained. Thus, when a subsequent data processing access occurs, the voltage drop (due to the surge in power to the consuming component) is minimized and processing speeds are not detrimentally affected.

As an example, the power consuming component could be a cache which is accessible by one or more data processing elements via one or more data ports. If none of the data processing elements are accessing the cache, the electrical power at the cache approaches zero. Then, when the cache is next accessed by at least one of the processing elements a voltage drop will occur at various points in the data processing system. The control circuit of the present invention monitors the access of the cache by the processing elements. If it is determined that no element is actively accessing the cache, then an "artificial" access is implemented by the control circuit to maintain a minimum voltage level. The minimum voltage level will reduce or eliminate any voltage spike, and still allow the power used by the consuming component to be regulated.

In accordance with the previous summary, objects, features and advantages of the present invention will become apparent to one skilled in the art from the subsequent description and the appended claims taken in conjunction with the accompanying drawings.

### Brief Description of the Drawings

Figure 1 is a block diagram of a central electronics complex (CEC) which includes the various instruction execution units, cache and memory;
Figure 2 is a schematic diagram showing the logical components of the control circuit of the present invention and its connections to a power consuming element, such as a cache;
Figure 3 is a timing diagram illustrating the problem addressed by the present invention;
Figure 4 is a block diagram of a multiprocessing system capable of implementing the present invention; and
Figure 5 is a schematic diagram of another preferred embodiment of the present invention wherein multiple control circuits are provided.

### Detailed Description of the Preferred Embodiment

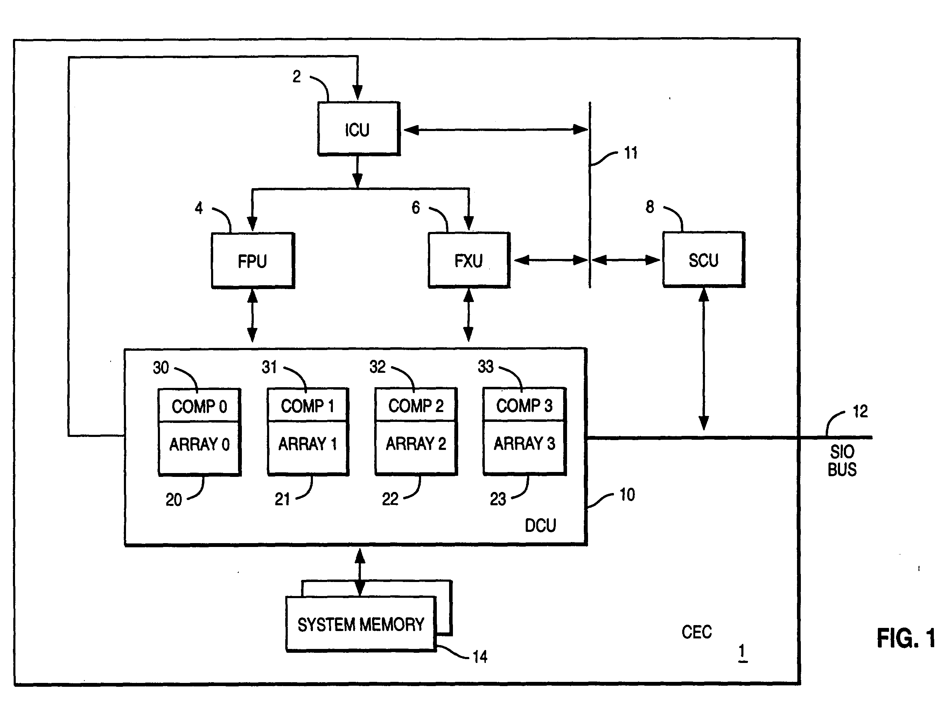

Referring to Figure 1, a central electronics complex (CEC) is shown for a typical microprocessor, such as a PowerPC microprocessor (PowerPC is a trademark of the IBM Corp) commercially available from IBM. An instruction cache unit 2 (ICU) is shown which provides various processing instructions to the microprocessor execution units. These instructions include LOAD, STORE, ADD, MULTIPLY, and the like in accordance with a specific microprocessor architecture, such as the PowerPC microprocessor architecture. ICU 2 supplies the instructions to a floating point unit (FPU) 4 and fixed point unit (FXU) 6. A storage control unit 8 is also provided which controls access to various memory elements, such as a level 2 (L2) cache. Additionally, SCU 8 provides an interface between CEC 1 and a system I/O bus 12. Internal bus 11 is used to interconnect SCU 8 with FXU 6 and ICU 2 for passing information therebetween. Both FPU 4 and FXU 6 are connected to a data cache unit (DCU) 10. It should be noted that ICU 2 and DCU 10 are collectively considered to be a level 1 (L1) cache. A system memory 14 is then hierarchically connected to DCU 10 such that information in memory 14 is normally provided to DCU 10, and then on to a requesting one of the data processing elements (e.g. FPU 4, FXU 6, SCU 8, etc.)

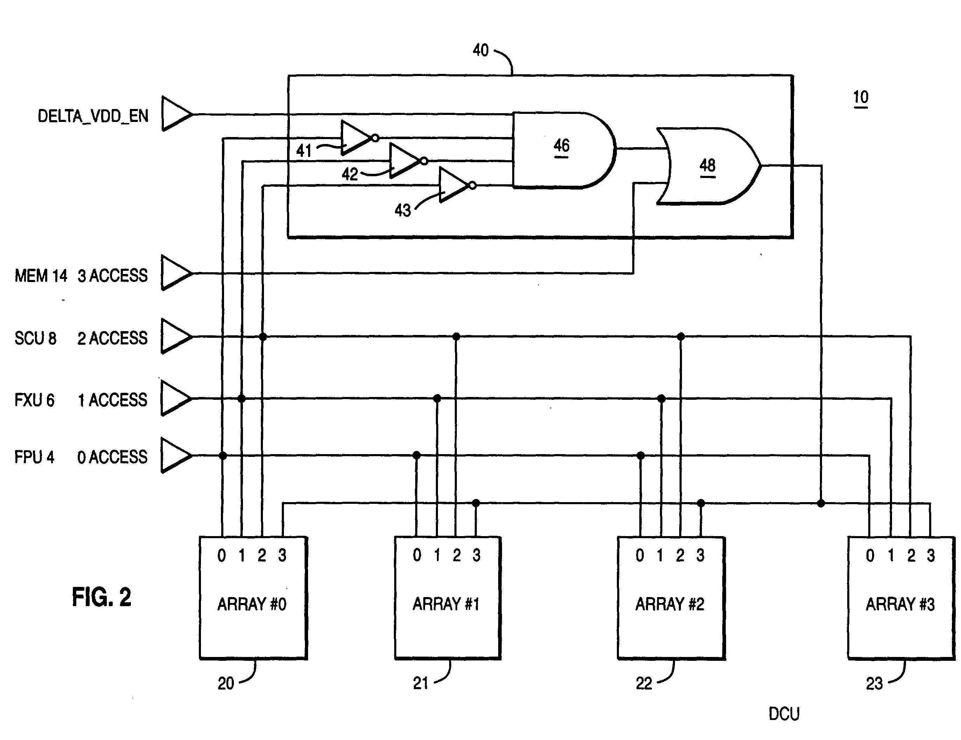

DCU 10 includes four (4) arrays 0, 1, 2, and 3 which are represented by reference numerals 20, 21, 22 and 23, respectively. As shown in Figure 2, each of these arrays include an access port 0, 1, 2, 3 for each processing element that has access to the array. Additionally, each array 20, 21, 22, 23 includes a comparator 30, 31, 32, 33, respectively, which is used to compare an address presented to the array, by a processing element, with an address location in the array.

It should be noted that during a compare operation, the logic circuits which implement the compare are active and consume a quantity of electrical power sufficient to prevent a voltage spike from occurring. That is, when the present invention determines that DCU 10 is idle, an access can be made with a "dummy" address (e.g. 32 zeros) such that the corresponding comparator 30-33 will consume enough electrical power to prevent a voltage drop. In this manner, an actual access of the cache (read or write operation with corresponding valid data) is not necessary to maintain a sufficient level of power consumption. Referring to Figure 2, the control circuit of the present invention is shown by reference numeral 40 and included in DCU 10. Further, arrays 20, 21, 22 and 23 are shown having ports 0, 1, 2, 3, which are connected to access inputs 0, 1, 2, 3. These access inputs may be connected to the various processing elements shown in Figure 1, such as FPU 4, FXU 6, SCU 8 and memory 14. Thus, each of these elements is capable of accessing information in arrays 0-3 independently of one another. Additionally, control circuit 40 is also electrically connected to each of the access inputs 0-3. Circuit 40 monitors the activity of the processing elements connected to inputs 0-3 and determines when none of the elements are actively accessing arrays 20-23. When no activity is detected, circuit 40 initiates an access to each array 20-23 by providing an address to comparators 30-33, contained in the arrays, such that a minimum level of power consumption is maintained.

More specifically, memory access inputs 0, 1, and 2 are input to inverters 41, 42 and 43, respectively. The output of these inverters, along with an enable signal is then input to an AND gate 46. The output of AND gate 46 and the input to access 3 is input to an OR gate 48. The output of OR gate 48 is provided to port 3 on each of arrays 20-23. It can be seen that control circuit 40 is provided in the input path of access 3, however, it could be provided in any one of access inputs 0, 1, 2, 3 and have equally acceptable results.

An example of the operation of the present invention, as shown in Figure 2 will now be described. When any one of the processing elements connected to access inputs 0-3 is active (logical 1) and accessing data in arrays 20-23, control circuit 40 merely performs a monitoring function. Specifically, assume that FPU 4 is currently accessing port 0 of arrays 20-23. Further assume that the remaining processing elements are inactive. In this case, a logical 1 will be input to inverter 41 and logical zeros will be input to inverters 42 and 43 from access inputs 1 and 2. Also, a logical 0 will be input to OR gate 48. It is also assumed that control circuit 40 is enabled and a logical 1 is provided to AND gate 46 by the DELTA_VDD_EN signal. Therefore, in addition to this enable signal (logical 1), the output of inverters 42 and 43 is a logical 1, which is also input to AND gate 46. However, the logical 1 input to inverter 41 is provided to AND gate 46 as a logical 0. Thus, the output of AND gate 46 is a logical 0 (three logical 1 inputs and one logical 0 inputs). This logical 0 from AND gate 46 is input to OR gate 48, along with the logical 0 from access input 3. Thus, the output of OR gate 48 is a logical 0 and no access of data port 3 of arrays 20-23 occurs. It can be seen that control circuit 40 is monitoring access inputs 0-3 and, in this case, FPU 4 connected to input 0 is actively accessing port 0 of arrays 20-23. Control circuit 40 has detected this activity and determines that no action need be taken. It can be seen that if any one (or more) of the processing elements connected to access inputs 0-3 active, then circuit 40 will detect this state and determine that no action is required.

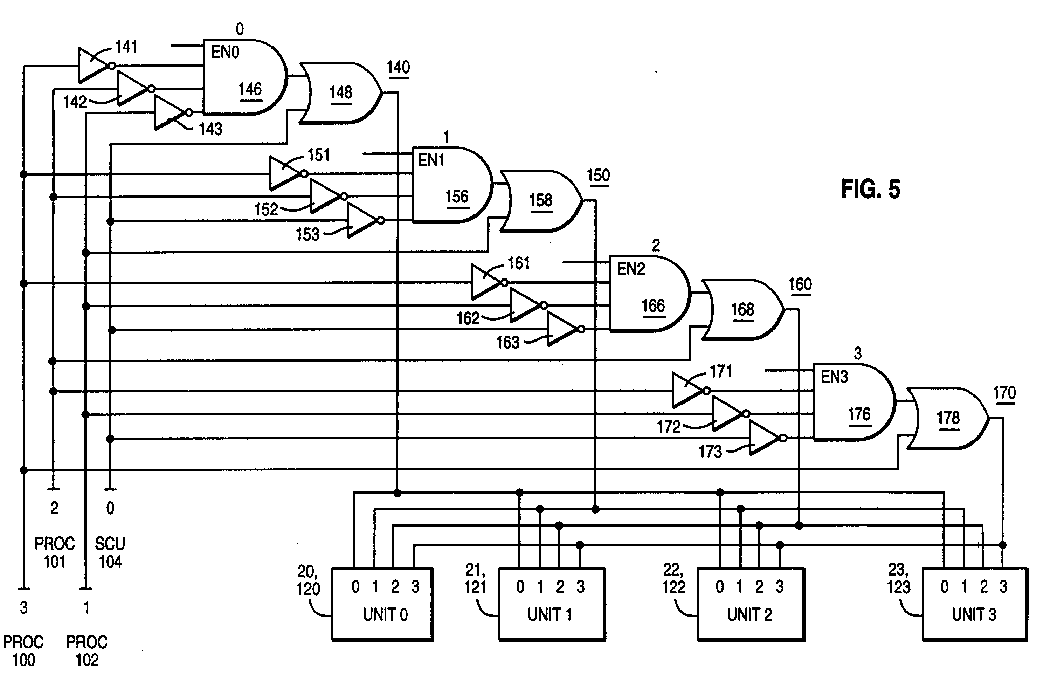

Next, the case where none of the processing elements are active will be described. In this example it is assumed that the state of each of access inputs 0-3 is inactive (i.e. a logical 0). Therefore, a logical 0 will be input to each of inverters 41, 42, and 43, which will then output a logical 1 to AND gate 46. Since the control circuit is enabled, another logical 1 will be provided to AND gate 46 as the DELTA_VDD_EN signal. Thus, a logical 1 is output from AND gate 46 (four inputs of logical 1). The logical 0 from access input 3 is input to OR gate 48, along with logical 1 from AND gate 46. Therefore, a logical 1 is output from control circuit 40 (OR gate 48) and an access is implemented at port 3 of arrays 20-23. It can be seen how control circuit 40 detects when all of the connected processing elements are inactive and in response implements an access cycle to arrays 20-23 in order to maintain a level of power consumption. In the aforementioned examples, it can be seen that the present invention maintains DCU 10 at approximately 25% of the electrical power it would use when fully accessed. That is, one port (3), which is 25% of the total ports available, is activated when control circuit 40 detects an inactive cycle. It can be seen that in some applications it may be advantageous to ensure that greater than 25% of the power is maintained, e.g. 50%, to keep the processing speed at an acceptably fast level. This situation will be described below, in more detail, in accordance with another preferred embodiment, as shown in Figure 5.

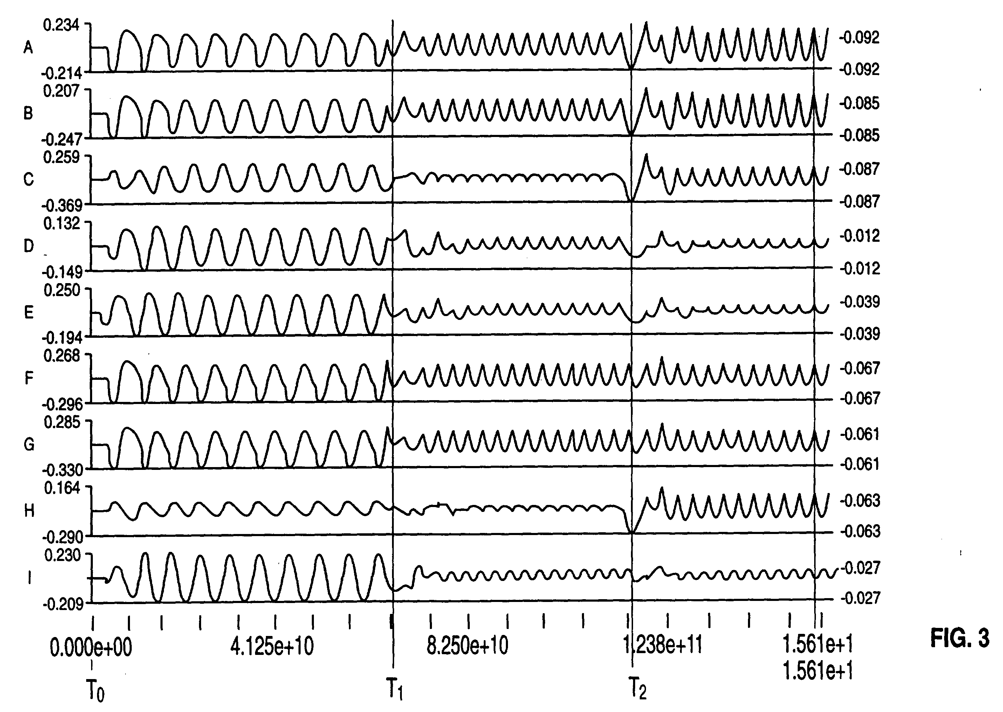

Figure 3 is a timing diagram illustrating the type of problem that the present invention solves. Those skilled in the art will understand that the voltage level will vary at various physical points in the system (whether the system is a single chip, or an entire, planar or computer). These voltage differences are caused by many different reasons, such as the physical characteristics of the circuits. That is, the actual materials, the spacing of the circuit lines, the proximity of certain components to one another, and the like, all combine to create an electrically unstable environment, such that when the system changes states (e.g components switch on or off) voltage fluctuations occur.

In Figure 3 nine (9) different points, A-I, in an electrical circuit were sampled for their voltage level at various times. At Tₒ, the system is in a steady state condition and the voltage level is acceptable at all points. Various components in the system are switched off at point T₁ and the frequency of the signal increases, but there is no significant voltage spike. However, at time T₂ a power consuming device, such as a cache is switched on and the voltage level drops to an unacceptable level at several of the sampled points. In particular, the voltage at points A, B, C and H have dropped to a point where data integrity is threatened (in addition to impacting processing speed). The voltage at point E is marginally acceptable, and the remaining voltage sample points do not appear to have a significant voltage drop. It can be seen that approximately 50% of the voltage sample points in the circuit have an unacceptable voltage spike, which can cause severe problems, including loss of processing speed while the transient voltage spike dissipates and loss of data which is being stored in register circuits, buffers, and the like.

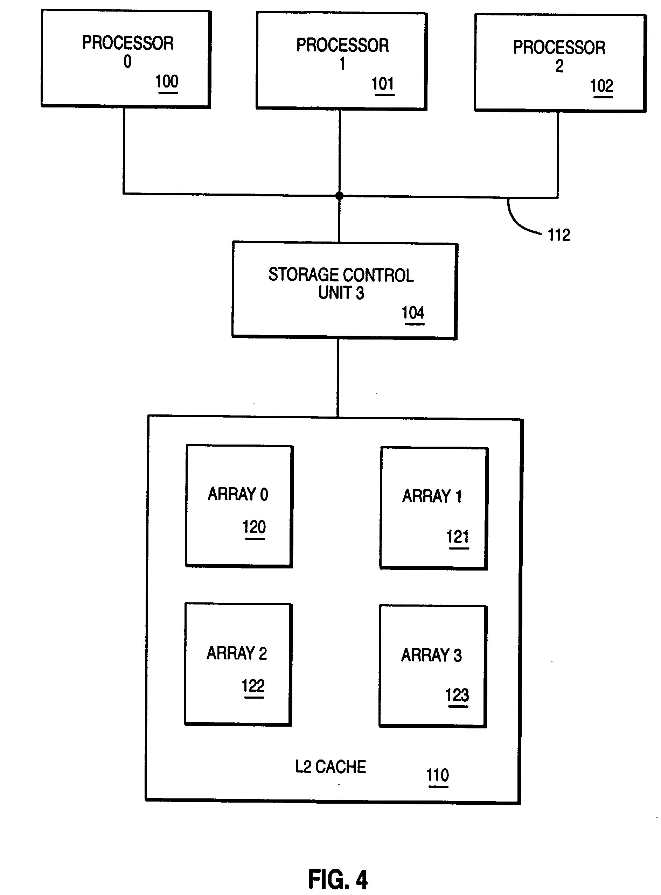

Figure 4 is a block diagram of a system having multiple processors 0, 1 and 2 represented by reference numerals 100, 101 and 102, respectively. A storage control unit (SCU) 104 (data processing element 3) is shown and interconnected with processors 100, 101 and 102, by a system bus 112. SCU 104 controls the access to a level 2 (L2) cache 110. L2 cache 110 includes four (4) arrays 0, 1, 2, 3, represented by reference numerals 120, 121, 122, 123, respectively. Each of the arrays 120-123 include a number of ports (0-3 in this embodiment) to allow concurrent access by the data processing elements (processors 100, 101, 102 and SCU 104). It can be seen that the embodiment of Figure 4 is a multiprocessor computer system, rather than a microprocessor, as shown in Figure 1. Thus, it should be understood that the present invention contemplates use in any electrical system having a power consuming component (e.g. DCU 10 and L2 cache 110) which causes a voltage drop when it is switched from an inactive to an active state. A control circuit, such as control circuit 40 of Figure 2 could be included in L2 cache 110, in the manner as previously described relative to Figure 2. In this embodiment of the present invention the data processing elements being monitored by the control circuit in L2 cache 110 would be processors 100, 101, 102 and SCU 104. If none of them were accessing cache 110, then the control circuit would initiate an access as described above.

Referring to Figure 5, another preferred embodiment of the present invention is shown. As noted previously, it would be advantageous to have more control over the amount of electrical power that is consistently consumed by caches 10 or 110. In the embodiment of Figure 5, control circuits 140, 150, 160 and 170 are included in each of the access inputs 0, 1, 2 and 3. As discussed previously, each of the access inputs is connected to a corresponding data port on an array 0-3, which may be arrays 20-23 or 120-123, depending on whether the cache is DCU 10 or L2 cache 110.

In this case, access input 0 is shown connected to SCU 104 as the data processing element and input to OR gate 148. The remaining access inputs 1, 2, 3 are input to inverters 141, 142 and 143. The output of these inverters and an enable signal, EN0, is input to an AND gate 146. The output of this AND gate is then input to OR gate 148 along with the input from access input 0.

Access input 1 is shown connected to processor 102 as the data processing element and input to OR gate 158. The remaining access inputs 0, 2, 3 are input to inverters 151, 152 and 153. The output of these inverters and an enable signal, EN1, is input to an AND gate 156. The output of this AND gate is then input to OR gate 158 along with the input from access input 1.

Access input 2 is connected to processor 101 as the data processing element and input to OR gate 168. The other access inputs 0, 1, 3 are input to inverters 161, 162 and 163. The output of these inverters and an enable signal, EN2, is input to an AND gate 166. The output of this AND gate is then input to OR gate 168 along with the input from access input 2.

Access input 3 is connected to processor 10 as the data processing element and input to OR gate 178. The other access inputs 0, 1, 2 are input to inverters 171, 172 and 173. The output of these inverters and an enable signal, EN3, is input to an AND gate 176. The output of this AND gate is then input to OR gate 178 along with the input from access input 3.

It can be seen from Figure 5 that by activating one or more enable signals (EN0, EN1, EN2, EN3) the corresponding control circuits will be set up to provide a cache access in the event that none of the processing elements are actually accessing the cache. That is, the enable signals allow various predetermined cache states to be selected. For example, if all of the enable signals are active and none of the data processing elements are accessing the cache, then all of the control circuits 140, 150, 160 and 170 will initiate an array access through their respective data ports. More specifically, if a logical 0 were input on each of access inputs 0-3, then a logical 0 would be provided to each of the OR gates 148, 158, 168 and 178. Further, the remaining logical 0's would be input to the corresponding inverters 141-143, 151-153, 161-163, 171-173 such that only logical 1's would be input to AND gates 146, 156, 166, 176. Therefore, a logical one would be output from each of control circuits 140, 150, 160 and 170, such that a comparator in each of arrays 0-3 would implement an address comparison between a generated address and an actual address location in the array, thereby causing a high level of electrical power to be consumed by the cache, since all data ports 0-3 on each array 0-3 are being accessed.

However, if it is determined that system performance is acceptable when only approximately 50% of the power is needed to maintain an appropriate voltage level, then only two of the controls circuits, e.g. 140 and 150 are enabled. In this case, all of the data processing elements are idle, relative to accessing the cache, and logical 0's are input to access inputs 0-3. The zeros on inputs 1, 2, 3 are input as logical 1's by inverters 141, 142 and 143 to AND gate 146, along with a logical 1 from the enable signal EN0. Thus, a logical 1 is output from AND gate 146 and input to OR gate 148. Further, a logical 0 is input to OR gate 148 from access input 0. Therefore, a logical 1 is output from control circuit 140 (OR gate 148) and an access to arrays 0-3 is made at port 0. Similarly, the zeros on inputs 0, 2, 3 are input as logical 1's by inverters 151, 152 and 153 to AND gate 156, along with a logical 1 from the enable signal EN1. Thus, a logical 1 is output from AND gate 156 and input to OR gate 158. Further, a logical 0 is input to OR gate 148 from access input 0. Therefore, a logical 1 is output from control circuit 150 (OR gate 158) and an access to arrays 0-3 is made at port 1. Based on the previous description, it can be seen how control circuits 140, 150, 160 and 170 can be switched on (and off) by enabling signals EN0-EN3.

In this manner a state of activity of power consuming devices can be variably regulated at both a chip and system level. The present invention provides a great deal of flexibility in optimizing power consumption while ensuring that data integrity and high frequency is maintained. Additionally, the present invention allows this power consumption optimization technique to be used not only during the design phase, but also after the circuit has been implemented in silicon. Further, those skilled in the art will comprehend how the present invention is not limited to store devices, such as a cache, but can be used with any component which consumes electrical power.

## Claims

1. A circuit for maintaining a storage unit, connected to a plurality of data processing devices, in a predetermined state, comprising:
means for determining when none of said plurality of data processing devices are accessing said storage unit; and
means for initiating an access cycle to said storage unit when none of said plurality of data processing devices are accessing said storage unit.

2. A circuit according to claim 1 wherein said means for determining comprises means for determining when a particular of said plurality of data processing devices are accessing said information from said storage unit.

3. A circuit according to any of the preceding claims wherein said means for initiating comprises means for providing an access request signal.

4. A circuit according to claim 3 further comprising means for activating said storage unit in response to receipt of said access request signal.

5. A circuit according to claim 4 wherein said means for activating comprises a comparator for matching an address presented by one of said plurality of data processing devices with an address corresponding to one of said plurality of locations.

6. A circuit according to claim 5 wherein said predetermined state is a specified voltage level.

7. A circuit according to claim 6 wherein said address matching by said comparator causes said storage unit to operate at said specified voltage level.

8. A circuit according to any preceding claim wherein said storage unit is a cache comprising a plurality of arrays with a corresponding said comparator.

9. A circuit according to claim 8 wherein said means for initiating further comprises means for providing a plurality of said access request signals to a predetermined fraction of said plurality of arrays.

10. A method for maintaining a storage unit, connected to a plurality of data processing devices, in a predetermined state, comprising the steps of:
determining when none of said plurality of data processing devices are accessing said storage unit; and
initiating an access cycle to said storage unit when none of said plurality of data processing devices are accessing said storage unit.

11. A method according to claim 10 wherein said step of determining comprises the step of determining when a particular number of said plurality of data processing devices are accessing said information from said storage unit.

12. A method according to claim 10 or 11 wherein said step of initiating comprises the step of providing an access request signal.

13. A method according to claim 12 further comprising the step of activating said storage unit in response to receipt of said access request signal.

14. A method according to claim 13 wherein said step of activating comprises the step of matching, by at least one comparator, an address presented by one of said plurality of data processing devices with an address corresponding to one of said plurality of locations.

15. A method according to claim 14 wherein said predetermined state is a specified voltage level.

16. A method according to claim 15 wherein said step of address matching by said comparator causes said storage unit to operate at said specified voltage level.

17. A method according to any claim between 10 and 16 wherein said storage unit is a cache comprising a plurality of arrays with a corresponding said comparator.

18. A method according to claim 17 wherein said step of initiating further comprises the step of providing a plurality of said access request signals to a predetermined fraction of said plurality of arrays.

19. A control apparatus for maintaining a first IC, connected to a plurality of other ICs, in a predetermined state, comprising:
means for determining when a particular number of said plurality of other ICs are communicating with said first IC; and
means for transmitting signals, by said control apparatus, to said first IC when none of said plurality of other ICs are communicating with said first IC.

20. An apparatus according to claim 19 wherein said means for transmitting comprises:
means for providing an activation request signal to said first IC; and
means for activating said first IC in response to receipt of said activation request signal.
